# EUROPÄISCHE PATENTSCHRIFT

(11) **EP 1 410 051 B1**
(45) Veröffentlichungstag und Bekanntmachung des Hinweises auf die Patenterteilung: **19.10.2005**
(21) Anmeldenummer: 01969398.5
(22) Anmeldetag: 17.07.2001
(51) Int. Cl.: G01R 31/00

(54) **VERFAHREN UND VORRICHTUNG ZUR PRÜFUNG VON ELEKTRISCHEN LEITUNGEN UND/ODER ELEKTRISCHEN VERBRAUCHERN IN EINEM FAHRZEUG AUF FEHLER**
METHOD AND DEVICE FOR CHECKING FOR ERRORS IN ELECTRICAL LINES AND/OR ELECTRICAL CONSUMERS IN A VEHICLE
PROCEDE ET DISPOSITIF DE CONTROLE DE DEFAUTS DANS DES LIGNES ELECTRIQUES ET/OU DES RECEPTEURS ELECTRIQUES D'UN VEHICULE

(30) Priorität: 19.07.2000 DE 10034664
(43) Veröffentlichungstag der Anmeldung: 21.04.2004
(73) Patentinhaber: Sentronik GmbH, 59174 Kamen (DE)
(72) Erfinder: MÖHLEN, Hartmut, 38533 Vordorf (DE); WATTENBERG, Jörg, 31135 Hildesheim (DE); SCHRAMM, Hans, Ulrich, 38179 Barleben (DE); JAUNSSEYFRIED, Stefanie, 38302 Wolfenbüttel (DE); ASCHE, Ralf, 38442 Wolfsburg (DE); NIERAESE, Ralph, 29392 Wesendorf (DE); SIEGEL, Georg, 59192 Bergkamen (DE)
(74) Vertreter: Schneider, Uwe
(86) Internationale Anmeldenummer: PCT/EP2001/008206
(87) Internationale Veröffentlichungsnummer: WO 2002/010782

(56) Entgegenhaltungen:
- EP-A- 0 716 311
- EP-A- 0 784 210
- WO-A-89/06839
- DE-A- 3 444 119
- DE-A- 19 612 891
- US-A- 4 700 126
- US-A- 5 671 158

## Beschreibung

Die Erfindung betrifft ein Verfahren und eine Vorrichtung zur Prüfung von elektrischen Leitungen und/oder elektrischen Verbrauchern in einem Fahrzeug auf Fehler, insbesondere auf Fehlsteckungen und Beschädigungen.

Kraftfahrzeuge werden regelmäßig mit einer Vielzahl von elektrischen Funktions- und Komforteinrichtungen ausgestattet, z.B. mit Frontscheinwerfern, Rückleuchten, Bremsleuchten, Blinkleuchten, Innenraumleuchten, elektrischen Lüftern, elektrischen Fensterhebem etc.. Bei der Montage dieser Einrichtungen und der hierfür erforderlichen elektrischen Leitungen kommt es immer wieder vor, daß Kabelverbindungen nicht oder nicht richtig gesteckt werden, sowie daß Kabel beschädigt oder mit Massekontakt verlegt werden. Werden solche Fehler erst festgestellt, wenn bereits Teppiche, Innenverkleidungen oder Sitze im Fahrzeug montiert sind, ist die Fehlerbehebung wegen der dann erforderlichen De- und Remontagearbeiten aufwendig und teuer.
Bekannt ist es, bei der Montage eines Kraftfahrzeuges elektrische Leitungen und elektrische Verbraucher unter Batteriespannung auf Fehler zu prüfen. Die Fahrzeugbatterie wird bei der Montage eines Kraftfahrzeuges jedoch üblicherweise erst relativ spät eingebaut, und zwar nachdem Teppiche, Innenverkleidungen oder Sitze bereits eingebaut sind. Es besteht zwar grundsätzlich die Möglichkeit, die Fahrzeugbatterie vor dem Einbau von Teppichen, Innenverkleidungen und Sitzen zu montieren, jedoch birgt die Prüfung unter Batteriespannung die Gefahr, daß elektrische Geräte und Steuermodule im Fahrzeug bei vorhandenen Fehlsteckungen oder Kabelbeschädigungen zerstört werden.

Der Stand der Technik ist in DE 19 612 891 (Volkswagen), 02.10.97 und EP 0 716 311 (Chrysler), 12.06.96 offenbart.

Der Erfindung liegt daher die Aufgabe zugrunde, ein Verfahren sowie eine Vorrichtung der eingangs genannten Art zu schaffen, die bereits während der Montage von elektrischen Leitungen und/oder elektrischen Verbrauchern in einem Fahrzeug deren sofortige Prüfung auf Fehler ermöglichen und dabei eine Zerstörung der zu prüfenden elektrischen Installation ausschließen.

Gelöst wird diese Aufgabe durch das Verfahren gemäß Anspruch 1 und die Vorrichtung gemäß Anspruch 10.

Das erfindungsgemäße Verfahren ist im wesentlichen durch folgende Schritte gekennzeichnet:
Einspeisen eines Frequenzsignals mit einer über einen einstellbaren Bereich automatisch variierten Frequenz und einem eine im wesentlichen spannungslose Prüfung ergebenden Spannungspegel in ein fehlerfreies Muster einer zu prüfenden elektrischen Installation in Form einer elektrischen Leitung und/oder eines elektrischen Verbrauchers und Ablegen eines sich aus dem Frequenz-Signal ergebenden Referenzmeßsignals in einem Speicher,
Einspeisen des gleichen Frequenzsignals in eine dem fehlerfreien Muster entsprechende zu prüfende elektrische Installation und Aufnehmen eines sich aus dem eingespeisten Frequenzsignal ergebenden Meßsignals,
Vergleichen des aufgenommenen Meßsignals mit dem im Speicher abgelegten Referenzmeßsignal bezüglich der Spannungsamplitude, der Laufzeitverschiebung der Frequenz, des Vorliegens von Nadelimpulsen und/oder des ohmschen Leitungswiderstandes, und
Signalisieren des Ergebnisses des Signalvergleiches.

Die erfindungsgemäße Vorrichtung ist dementsprechend gekennzeichnet durch eine Einrichtung zur Erzeugung eines Frequenzsignals, das eine über einen einstellbaren Bereich automatisch variierte Frequenz und einen eine im wesentlichen spannungslose Prüfung ergebenden Spannungspegel aufweist, eine Einrichtung zur Speicherung eines Referenzmeßsignals, das durch Einspeisung des Frequenzsignals in ein fehlerfreies Muster einer zu prüfenden elektrischen Installation in Form einer elektrischen Leitung und/oder eines elektrischen Verbrauchers ermittelt wird, eine Einrichtung zur Aufnahme eines sich aus dem eingespeisten Frequenzsignal ergebenden Meßsignals, eine Einrichtung zur Signalauswertung, die das aufgenommene Meßsignal mit dem gespeicherten Referenzmeßsignal bezüglich der Spannungsamplitude, der Laufzeitverschiebung der Frequenz, des Vorliegens von Nadelimpulsen und/oder des ohmschen Leitungswiderstandes vergleicht, und eine Einrichtung, die das Ergebnis des Signalvergleiches signalisiert und/oder anzeigt.

Das erfindungsgemäße Verfahren bzw. die erfindungsgemäße Vorrichtung ermöglichen eine sehr einfache, genaue und zuverlässige Prüfung einer elektrischen Leitung und/oder eines elektrischen Verbrauchers eines Kraftfahrzeuges auf Kabelunterbrechungen, Halb- bzw. Fehlsteckungen sowie Masseschluß in einem im wesentlichen spannungslosen Zustand, d.h. in einem leistungslosen Zustand mit einer Spannung kleiner 0,7 Volt, vorzugsweise kleiner 0,5 Volt. Dabei können etwaige Fehler im Bordnetz räumlich lokalisiert werden. Mit dem erfindungsgemäßen Verfahren bzw. der erfindungsgemäßen Vorrichtung lassen sich insbesondere auch sehr feine Drähte einer elektrischen Installation, insbesondere eines elektrischen Verbrauchers zerstörungsfrei prüfen.

Bevorzugte und vorteilhafte Ausgestaltungen der Erfindung sind in den Unteransprüchen angegeben.

Nachfolgend wird die Erfindung mit Bezug auf eine ein Ausführungsbeispiel darstellende Zeichnung näher erläutert. Es zeigen:
- Fig. 1: ein Blockschaltbild einer erfindungsgemäßen Vorrichtung,
- Fig. 2: einen ordnungsgemäß verbundenen Kabelverbinder (Steckverbinder),
- Fig. 3: einen schlecht verbundenen Kabelverbinder (Fehlsteckung),
- Fig. 4: den zeitlichen Verlauf eines Frequenzimpulses auf einem Oszilloskop bei der Messung einer ordnungsgemäß verlegten elektrischen Leitung mit einem ordnungsgemäß verbundenen Kabelverbinder (Steckverbinder) gemäß Fig. 2 (Referenzmessung),
- Fig. 5: den zeitlichen Verlauf des Frequenzimpulses auf dem Oszilloskop bei der Messung der elektrischen Leitung, wenn der Kabelverbinder (Steckverbinder) gemäß Fig. 3 schlecht oder gar nicht verbunden ist,
- Fig. 6: eine Oszilloskopanzeige mit überlagerten Frequenzimpulsverläufen, wobei die Messung einer elektrischen Leitung, die einen ordnungsgemäß verbundenen Kabelverbinder (Steckverbinder) aufweist, und eine entsprechende Referenzmessung überlagert sind sowie die Differenz aus beiden Messungen dargestellt ist,
- Fig. 7: eine Oszilloskopanzeige gemäß Fig. 6, wenn der Kabelverbinder (Steckverbinder) gemäß Fig. 3 schlecht oder gar nicht gesteckt ist,
- Fig. 8: eine Signalanzeige auf einem Frequenzspektrumanalysator bei der Messung einer ordnungsgemäß verlegten elektrischen Leitung, die einen ordnungsgemäß verbundenen Kabelverbinder (Steckverbinder) gemäß Fig. 2 aufweist (Referenzmessung),
- Fig. 9: eine Signalanzeige gemäß Fig. 8, wenn der Kabelverbinder (Steckverbinder) gemäß Fig. 3 schlecht oder gar nicht gesteckt ist (Fehlsteckung), und
- Fig. 10: eine die Differenz aus Referenzmessung und Messung einer Fehlsteckung darstellende Signalanzeige auf einem Frequenzspektrumanalysator.

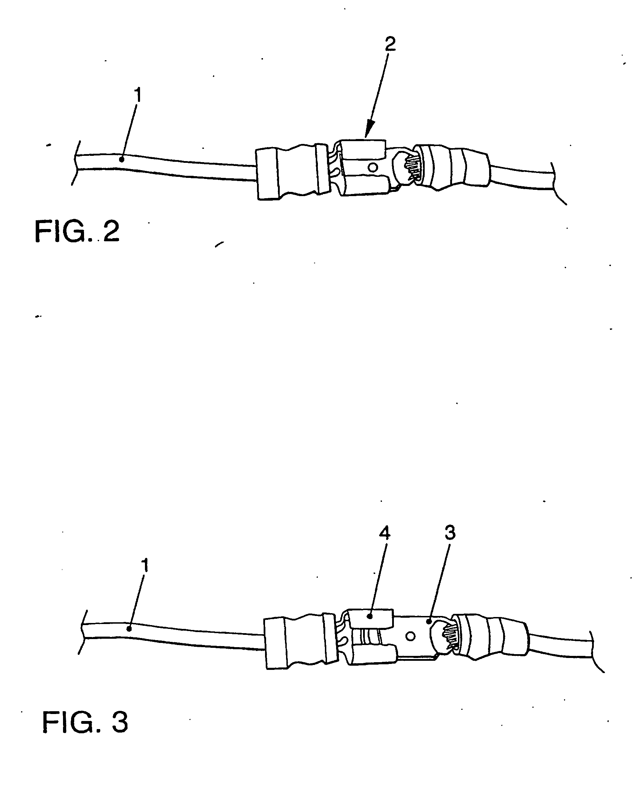

Ein häufiger Fehler in Bordnetzen von Kraftfahrzeugen ist die sogenannte Halbsteckung von Kabelverbindern (Steckverbindern). Fig. 2 zeigt einen Kabelabschnitt einer elektrischen Leitung 1 mit einem einwandfrei verbundenen Kabelverbinder 2. Fig. 3 zeigt denselben Kabelverbinder 2, der in diesem Fall jedoch schlecht verbunden ist, da das Steckerzungenteil 3 nicht vollständig in die komplementäre Steckerzungenklemme 4 eingesteckt ist Eine Halbsteckung gemäß Fig. 3 wird nachfolgend allgemein als Fehlsteckung bezeichnet.

Derartige Fehlsteckungen können erfindungsgemäß dadurch ermittelt werden, daß zunächst ein mit einem Signalgenerator erzeugtes Frequenzimpuls-Signal in ein fehlerfreies Muster einer zu prüfenden elektrischen Leitung bzw. eines zu prüfenden elektrischen Verbrauchers gemäß Fig. 2 eingespeist wird. Der Spannungspegel des Frequenzimpuls-Signals ist so bemessen, daß sich eine im wesentlichen spannungslose bzw. leistungslose Prüfung ergibt und somit auch feinste Drähte zerstörungsfrei geprüft werden können. An offenen Enden, Abzweigungen und/oder Querschnittsänderungen der elektrischen Leitung oder des angeschlossenen Verbrauchers wird das Frequenzsignal reflektiert bzw. verändert (Laufzeitunterschiede, Spannungsamplitude, Frequenzveränderung, usw.). An derselben Stelle, an der das Frequenzimpuls-Signal in die Leitung (dies kann auch ein Massepunkt an der Karosserie sein) eingespeist wird, erfolgt auch die Messung des reflektierten bzw. veränderten Signals. Das bei der Messung des fehlerfreien Musters aufgenommene Meßsignal wird dann als Referenzmeßsignal in einem Speicher abgelegt.

Anschließend werden elektrische Leitungen und/oder elektrische Verbraucher, die dem fehlerfreien Muster entsprechen, geprüft, indem das gleiche Frequenzimpuls-Signal an der gleichen Stelle in die zu prüfende elektrische Leitung bzw. den zu prüfenden elektrischen Verbraucher eingespeist und an derselben Stelle (Signaleinspeisepunkt) wiederum das sich aus dem eingespeisten Frequenzimpuls-Signal durch Reflektion bzw. Veränderung ergebende Meßsignal aufgenommen wird.

Das aufgenommene Meßsignal wird dann mit dem im Speicher abgelegten Referenzmeßsignal bezüglich der Spannungsamplitude, der Laufzeitverschiebung der Frequenz, des Vorliegens von Nadelimpulsen, des ohmschen Leitungswiderstandes und/oder einer frequenzbezogenen Stromveränderung verglichen und das Ergebnis des Signalvergleiches in geeigneter Weise optisch angezeigt und/oder akustisch signalisiert.

Damit lassen sich verbrauchertypische Referenzen ermitteln, die durch einfache Vergleichsmessungen in bezug auf ihren Einbauort, richtigen Anschluß, richtiges Gerät bzw. Verbraucher eine fehlerfreie Funktion nach Anlegen der Batteriespannung gewährleisten.

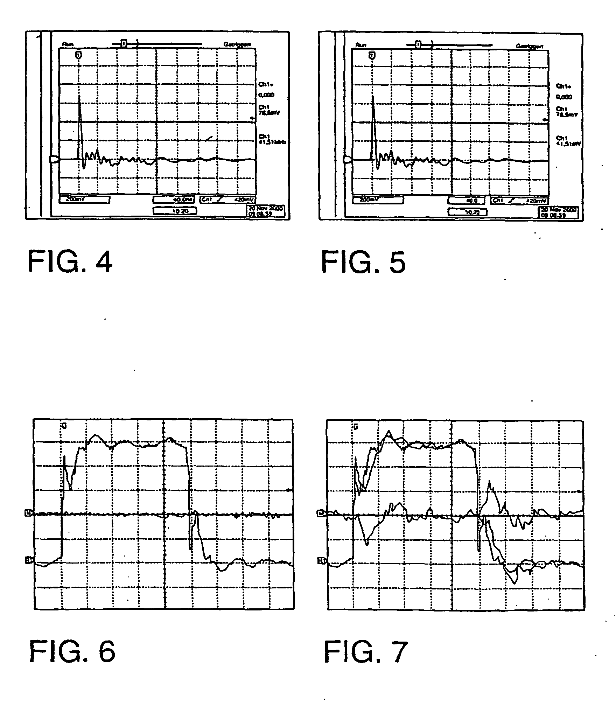

Die Figuren 4 und 5 zeigen Messungen im Zeitbereich, und zwar den Frequenz-Impuls auf einem Oszilloskop (X-Achse = Zeitachse) bei der Messung einer ordnungsgemäß verlegten elektrischen Leitung mit einem ordnungsgemäß verbundenen Kabelverbinder (Fig. 4, Referenzmessung) bzw. bei der Messung einer entsprechenden zu prüfenden elektrischen Leitung, die eine Fehlsteckung aufweist (Fig. 5). Bei einem Vergleich der beiden Oszilloskopanzeigen lassen sich lediglich anhand der Welligkeit des jeweiligen Frequenz-Impulses gewisse Unterschiede erkennen. Die Unterschiede werden deutlicher erkennbar, wenn die Referenzmessung und die Messung der zu prüfenden elektrischen Installation zusammen in einer Anzeige überlagert dargestellt werden und die Differenz aus Referenzmessung und Prüfmessung gebildet und angezeigt wird. Dies ist bei den Anzeigen gemäß den Figuren 6 und 7 der Fall.

Fig. 6 zeigt den Fall, in welchem die zu prüfende Leitung bzw. der zu prüfende Verbraucher fehlerfrei ist. Die Signalverläufe von Referenzmessung und Prüfmessung sind im wesentlichen deckungsgleich, so daß die den Differenzbetrag aus beiden Messungen wiedergebende Amplitude praktisch kaum von der mittleren Horizontallinie M abweicht. Fig. 7 zeigt dagegen den Fall, in welchem die zu prüfende Leitung eine Fehlsteckung aufweist. Es ist deutlich zu erkennen, daß die Signalverläufe von Referenzmessung und Prüfmessung nicht deckungsgleich sind. Dementsprechend weicht auch die den Differenzbetrag aus beiden Messungen wiedergebende Amplitude in mehreren Zeitabschnitten relativ stark von der mittleren Horizontallinie M ab.

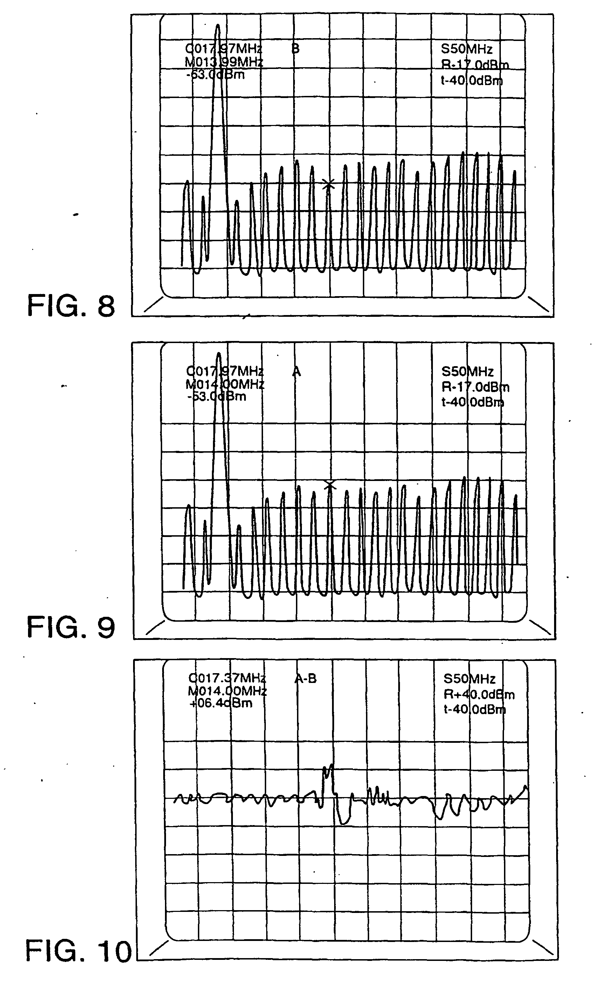

Die Welligkeit des Frequenz-Impulses spiegelt sich darüber hinaus auch im Frequenzspektrum wider. Die Figuren 8 und 9 zeigen Messungen im Frequenzbereich, und zwar den Frequenz-Impuls auf einem Frequenzspektrumanalysator (X-Achse = Frequenz), wobei Fig. 8 die Referenzmessung einer ordnungsgemäß verlegten elektrischen Leitung mit einem ordnungsgemäß verbundenen Kabelverbinder gemäß Fig. 2 betrifft, wohingegen Fig. 9 die Messung einer entsprechenden Leitung betrifft, die jedoch eine Fehlsteckung gemäß Fig. 3 aufweist. Beim Vergleich der beiden angezeigten Frequenzspektren ist an der sechsten Oberwelle, welche jeweils durch ein X markiert ist, ein deutlicher Unterschied in der Amplitude des Frequenz-Impulses erkennbar. Dieser Unterschied läßt sich besonders schnell erkennen, wenn auf dem Frequenzspektrumanalysator, wie in Fig. 10 gezeigt, die Differenz aus der Referenzmessung gemäß Fig. 8 und der Prüfmessung gemäß Fig. 9 angezeigt wird. Die der sechsten Oberwelle entsprechende Stelle ist dabei wiederum durch ein X markiert.

Die Figuren-4 bis 10 machen deutlich, daß anhand signifikanter Meßsignale auf das Vorliegen oder Nichtvorliegen von Fehlsteckungen in einer elektrischen Installation schnell und zuverlässig geschlossen werden kann. Darüber hinaus können mit dem erfindungsgemäßen Verfahren insbesondere auch Kurzschlüsse zur Masse oder zu anderen Kabeln oder in Verbrauchern festgestellt werden.

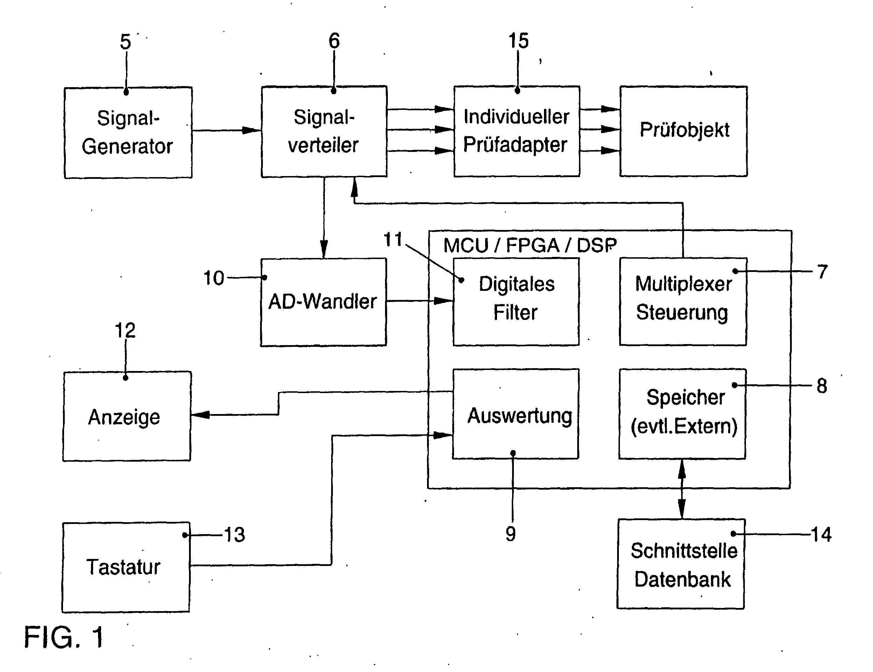

In Fig. 1 ist der Aufbau einer erfindungsgemäßen Vorrichtung schematisch dargestellt. Die Vorrichtung umfaßt eine Einrichtung zur Erzeugung eines Frequenzsignals (NF- /HF-Signal), welches eine konstante oder variable Frequenz und einen eine im wesentlichen spannungslose Prüfung ergebenden Spannungspegel aufweist. Die Einrichtung zur Erzeugung eines Frequenzsignals besteht aus einem Frequenz-Generator 5 mit einer Einrichtung zur Frequenzaufbereitung und einer Teilerschaltung in Form eines Signalverteilers 6. Der Signalverteiler 6 wird durch eine Multiplexer-Steuerung 7 gesteuert. Die Einrichtung zur Frequenzaufbereitung kann eine Einrichtung zur Abstimmung und/oder zur automatischen Erhöhung der Frequenz umfassen, so daß ein automatisches Frequenzscanning (Wobbeln) möglich ist.

Weiter umfaßt die Vorrichtung eine Einrichtung 8 zur Speicherung eines Referenzmeßsignals, das durch Einspeisung des hochfrequenten Signals in ein fehlerfreies Muster einer zu prüfenden elektrischen Installation (Prüfobjekt) in Form einer elektrischen Leitung und/oder eines elektrischen Verbrauchers ermittelt wird.

Ferner umfaßt die Vorrichtung eine Einrichtung zur Aufnahme eines sich aus dem eingespeisten Signal ergebenden Meßsignals (Reflektionsspannung, Spannungsamplitude, Frequenzänderung, Laufzeitunterschied usw.) sowie eine Einrichtung 9 zur Signalauswertung, die das aufgenommene Meßsignal mit dem gespeicherten Referenzmeßsignal bezüglich der Spannungsamplitude, der Laufzeitverschiebung der Frequenz, des Vorliegens von Nadelimpulsen, des ohmschen Leitungswiderstandes und/oder einer frequenzbezogenen Stromveränderung vergleicht. Die Einrichtung 9 zur Signalauswertung kann mit einem 16-Bit / 32-Bit Analog-Digital-Wandler 10 und einer FPGA-Logik versehen sein, wobei dem Analog-Digital-Wandler 10 ein digitales Signalfilter 11 nachgeschaltet ist.

Die Verwendung eines sogenannten DSP-Bausteines ist ebenfalls möglich, um die ermittelten Meßwerte zu speichern.

Weiter ist die Vorrichtung mit einer Anzeigeeinrichtung 12 ausgestattet, die das Ergebnis des Signalvergleiches signalisiert. In dem dargestellten Ausführungsbeispiel ist die Anzeigeeinrichtung 12 mit einer Tastatur 13 kombiniert. Zusätzlich kann die Anzeigeeinrichtung 12 auch mit einer akustischen Signaleinrichtung kombiniert sein.

Die vorgenannten Komponenten der Vorrichtung werden von einem sehr schnellen Mikrokontroller angesteuert. An dem Mikrokontroller ist mindestens eine Datenschnittstelle 14 angeschlossen, über die Referenzwerte, Toleranzgrenzen und/oder Prüfmasken in die Vorrichtung eingebbar und/oder Meßdaten auf andere Einrichtungen übertragbar sind. Die Datenschnittstelle kann insbesondere für eine drahtlose Datenübertragung, z.B. eine Funkübertragung, hergerichtet sein.

Die Vorrichtung ist vorzugsweise in Form eines leicht zu handhabenden Handgerätes ausgeführt, dessen Spannungsversorgung über Batterien und/oder Akkumulatoren realisiert ist. Alternativ kann die Vorrichtung aber auch vorteilhaft als flexibles Standgerät ausgebildet sein, das mit Netzstrom betreibbar ist. Das Handgerät bzw. das Standgerät kann in Modulartechnik mit erweiterungsfähigen Steckkarten auf PC-Basis-Hybridtechnologie aufgebaut sein. Ferner können sowohl das Handgerät als auch das Standgerät eine PFID-Leseeinheit für Read-Only und/oder Read-Write-Transponder enthalten. Alternativ oder zusätzlich kann das Handgerät bzw. das Standgerät eine Strichcode-Leseeinheit enthalten.

Zur Prüfung des Bordnetzes eines Kraftfahrzeuges wird mit der erfindungsgemäßen Vorrichtung in jede zu prüfende elektrische Leitung bzw. in jedes zu prüfende Gerät (Prüfobjekt) ein Frequenzsignal eingespeist, das eine konstante oder variable Frequenz aufweist. Der Spannungspegel des Frequenzsignals liegt bei maximal 700 mV, vorzugsweise bei maximal 500 mV. Durch diesen sehr geringen Spannungspegel wird der kritische Spannungspegel, bei dem einige elektronische Bauelemente bereits angesprochen werden können, unterschritten. Das eingespeiste NF- oder HF-Signal liegt vorzugsweise im Frequenzbereich von 10 MHz bis in den Ultraschallbereich hinein. Die Messung des an offenen Enden, Abzweigungen, Querschnittsänderungen und dergleichen reflektierten Frequenzsignals erfolgt, wie bereits erwähnt, an der gleichen Stelle, an der das Frequenzsignal in die zu prüfende elektrische Leitung bzw. in das zu prüfende Gerät eingespeist wird. Zur Messung des Signals wird zunächst eine Quantisierung des Wellenwiderstandes durchgeführt (Strecke der Hin- und Rückleitung). Diese Art der Meßdatenauswertung wird durch Ermitteln des Reflektionssignals, d.h. durch Ermitteln des Ausschwingens des Speisefrequenzsignals in der Leitung - auch als Echoantwort bezeichnet - durchgeführt.

Eine weitere Methode der Meßdatenauswertung erfolgt durch Ermitteln der Frequenzveränderung der Spannungsamplitude des angeschlossenen Verbrauchers bzw. der angeschlossenen Leitung (ohmsche Last, induktive Last, Siliziumstrecke bei Halbleitern). Die Leitung sowie gerätetypische Referenzdaten werden durch Vergleich ausgewertet.

Es kann grundsätzlich zwischen folgenden drei Leitungsgruppen unterschieden werden:
a) Rein ohmsche Verbraucher wie z.B. Glühlampen, Halogenlampen, Relais, usw.
b) Induktive Verbraucher wie z.B. Lichtmaschinen, Anlasser, Scheibenwischer, Benzinpumpen, elektrische Fensterheber, usw.
c) Leitungen wie z.B. Masseleitungen, 12 Volt Leitungen, Meßleitungen, Fühlerleitungen, Steuerleitungen und Schalt-Kontaktleitungen.

Jede dieser Leitungen bzw. jeder dieser Verbraucher wird im fehlerfreien Zustand ein bestimmtes Meßsignal liefern. Dieses Meßsignal wird als Muster in dem FPGA-Baustein, dem Mikrokontroller sowie dem Speicher, bei dem es sich um ein individuelles Speichermedium, z.B. ein S RAM oder D RAM handeln kann, abgelegt.

Über die mindestens eine Datenschnittstelle 14 können fahrzeug- bzw. modellspezifische Referenzwerte, insbesondere Toleranzgrenzen, und Prüfmasken mit verschiedenen Menüs auf die Vorrichtung übertragen werden. Darüber hinaus umfaßt die Vorrichtung auch einen austauschbaren individuellen Prüfadapter 15, der ein Speichermedium aufweist, auf dem ein oder mehrere fahrzeug- bzw. modellspezifische Referenzsignale, Toleranzgrenzen und/oder eine Prüfmaske gespeichert und/oder speicherbar sind. Durch ein software-gesteuertes Menü wird dem jeweiligen Prüfer nach Bekanntwerden eines Anschluß-Belegplanes, im welchem alle in einem bestimmten Fahrzeug zu installierenden Leitungen und elektrischen Geräte aufgeführt sind, eine Prüfmaske auf der Anzeigeeinrichtung 12 angezeigt. Jedes neu hinzugefügte Kabel oder Gerät wird geprüft und dabei sofort einem Vergleich durch die FPGA-Einheit unterzogen, so daß sofort erkannt wird, ob ein Fehler vorliegt oder nicht. Das jeweilige Meßergebnis wird auf der Anzeigeeinrichtung 12 sichtbar gemacht, wobei auch akustische Signale ertönen können, die gegebenenfalls das Vorliegen eines Fehlers zusätzlich signalisieren. Zur Fehlersuche kann der zu prüfende Bordnetzabschnitt geometrisch auf der Anzeigeeinrichtung 12 dargestellt und die möglichen Fehlerquellen angezeigt werden.

Die aufgenommenen Meßdaten werden gespeichert, z.B. auf einem Read / Write Transponder. Sie werden vorzugsweise drahtlos, z.B. per Funk, auf eine zentrale Serverstation übertragen und dort zur Erstellung eines Meßprotokolls gespeichert. Dies kann vorzugsweise vollautomatisch erfolgen.

Mit der beschriebenen Frequenz-Impuls-Prüfmessung kann auch bei z.B. zweiadrigen Leitungen, wie etwa Lautsprecherleitungen, genau ermittelt werden, welche der Leitungen gegebenenfalls einen Kurzschluß zur Masse aufweist, und zwar ohne daß beide Leitungen gemessen werden müssen.

## Patentansprüche

1. Verfahren zur Prüfung von elektrischen Leitungen und/oder elektrischen Verbrauchern in einem Fahrzeug auf Fehler, insbesondere auf Fehlsteckungen und Beschädigungen, mit den Schritten:
Einspeisen eines Frequenzsignals mit einer über einen einstellbaren Bereich automatisch variierten Frequenz und einem eine im wesentlichen spannungslose Prüfung ergebenden Spannungspegel in ein fehlerfreies Muster einer zu prüfenden elektrischen Installation in Form einer elektrischen Leitung und/oder eines elektrischen Verbrauchers und Ablegen eines sich aus dem Frequenzsignal ergebenden Referenzmeßsignals in einem Speicher,
Einspeisen des gleichen Frequenzsignals in eine dem fehlerfreien Muster entsprechende zu prüfende elektrische Installation und Aufnehmen eines sich aus dem eingespeisten Frequenzsignal ergebenden Messsignals,
Vergleichen des aufgenommenen Meßsignals mit dem im Speicher abgelegten Referenzmeßsignal, und
Signalisieren des Ergebnisses des Signalvergleiches.

2. Verfahren nach Anspruch **1, dadurch gekennzeichnet, daß** das Frequenzsignal in das Muster sowie die zu prüfende elektrische Installation jeweils einseitig eingespeist wird, wobei das Meßsignal bzw. Referenzmeßsignal an der jeweiligen Signaleinspeisestelle aufgenommen wird.

3. Verfahren nach Anspruch 1 oder 2, **dadurch gekennzeichnet, daß** bei einer Abweichung des aufgenommenen Meßsignals von dem Referenzmeßsignal um einen vorgebbaren Toleranzwert eine Fehlermeldung signalisiert wird.

4. Verfahren nach einem der Ansprüche 1 bis 3, **dadurch gekennzeichnet, daß** das Ergebnis des Signalvergleiches optisch angezeigt und/oder akustisch signalisiert wird.

5. Verfahren nach einem der Ansprüche 1 bis 4, **dadurch gekennzeichnet, daß** die zu prüfende elektrische Installation auf einer Anzeigeeinrichtung schematisch dargestellt und durchzuführende Prüfschritte in einer Prüfmaske auf der Anzeigeeinrichtung angezeigt werden.

6. Verfahren nach einem der Ansprüche 1 bis 5, **dadurch gekennzeichnet, daß** anhand des Signalvergleichs Fehlerarten ermittelt und auf einer Anzeigeeinrichtung signalisiert werden.

7. Verfahren nach einem der Ansprüche 1 bis 6, **dadurch gekennzeichnet, daß** ein Meßdatenprotokoll erstellt und gespeichert wird.

8. Verfahren nach Anspruch 7, **dadurch gekennzeichnet, daß** das Erstellen und Speichern des jeweiligen Meßdatenprotokolls vollautomatisch erfolgt.

9. Verfahren nach Anspruch 7 oder 8, **dadurch gekennzeichnet, daß** das Meßdatenprotokoll an eine zentrale Meßdatenerfassung drahtlos übertragen wird.

10. Vorrichtung zur Prüfung von elektrischen Leitungen und/oder elektrischen Verbrauchern in einem Fahrzeug auf Fehler, insbesondere auf Fehlsteckungen und Beschädigungen, mit
einer Einrichtung (5, 6) zur Erzeugung eines Frequenzsignals mit einer über einen einstellbaren Bereich automatisch variierten Frequenz und einem eine im wesentlichen spannungslose Prüfung ergebenden Spannungspegel,
einer Einrichtung (8) zur Speicherung eines Referenzmesssignals, das durch Einspeisung des Frequenzsignals in ein fehlerfreies Muster einer zu prüfenden elektrischen Installation in Form einer elektrischen Leitung und/oder eines elektrischen Verbrauchers ermittelt wird, einer Einrichtung zur Aufnahme eines sich aus dem eingespeisten Frequenzsignal ergebenden Messsignals,
einer Einrichtung (9) zur Signalauswertung, die das aufgenommene Meßsignal mit dem gespeicherten Referenzmeßsignal vergleicht, und
einer Einrichtung (12), die das Ergebnis des Signalvergleiches signalisiert.

11. Vorrichtung nach Anspruch 10, **dadurch gekennzeichnet, daß** die Einrichtung zur Erzeugung eines Frequenzsignals einen Frequenz-Generator (5), eine Einrichtung zur Frequenzaufbereitung und eine Teilerschaltung (6) aufweist.

12. Vorrichtung nach Anspruch 10 oder 11, **dadurch gekennzeichnet, daß** die Einrichtung (9) zur Signalauswertung mit einem Analog-Digital-Wandler (10) und einer programmierbaren Logik versehen ist.

13. Vorrichtung nach Anspruch 12, **dadurch gekennzeichnet, daß** dem Analog-Digital-Wandler (10) ein digitales Signalfilter (11) nachgeschaltet ist.

14. Vorrichtung nach einem der Ansprüche 10 bis 13, **dadurch gekennzeichnet, daß** des weiteren ein oder mehrere Mikrokontroller vorhanden sind, welche die Komponenten der Vorrichtung steuern.

15. Vorrichtung nach einem der Ansprüche 10 bis 14, **dadurch gekennzeichnet, daß** die Vorrichtung des weiteren einen austauschbaren Prüfadapter (15) umfaßt, der ein Speichermedium aufweist, auf dem ein oder mehrere fahrzeugspezifische Referenzsignale, Toleranzgrenzen und/oder eine Prüfmaske gespeichert und/oder speicherbar sind.

16. Vorrichtung nach einem der Ansprüche 10 bis 15, **dadurch gekennzeichnet, daß** mindestens eine Datenschnittstelle (14) vorhanden ist, über die Referenzsignale, Toleranzgrenzen und/oder Prüfmasken in die Vorrichtung eingebbar und/oder Meßdaten auf andere Einrichtungen übertragbar sind.

17. Vorrichtung nach Anspruch 16, **dadurch gekennzeichnet, daß** die Datenschnittstelle (14) für eine drahtlose Übertragung von Daten hergerichtet ist.

18. Vorrichtung nach einem der Ansprüche 10 bis 17, **dadurch gekennzeichnet, daß** die Einrichtung (12) zur Signalisierung des Signalverglelchs aus einer optischen Anzeigeeinrichtung und/oder einer akustischen Signaleinrichtung besteht

19. Vorrichtung nach einem der Ansprüche 10 bis 18, **dadurch gekennzeichnet, daß** des weiteren eine Eingabeeinrichtung in Form von Bedienelementen, einer Tastatur und/oder eines Touch-Screens vorhanden ist.

20. Vorrichtung nach einem der Ansprüche 10 bis 19, **dadurch gekennzeichnet, daß** sie als batterie- und/oder akkumulatorbetriebenes Handgerät ausgebildet ist.

21. Vorrichtung nach einem der Ansprüche 10 bis 20, **dadurch gekennzeichnet, daß** sie als batterie- und/oder akkumulatorbetriebenes Handgerät ausgebildet und in Modulartechnik aufgebaut ist.

22. Vorrichtung nach einem der Ansprüche 10 bis 19, **dadurch gekennzeichnet, daß** sie als flexibel fahrbares Standgerät ausgebildet und mit Netzstrom betreibbar ist.

23. Vorrichtung nach Anspruch 22, **dadurch gekennzeichnet, daß** sie als flexibel fahrbares Standgerät ausgebildet und in Modulartechnik aufgebaut ist.

24. Vorrichtung nach einem der Ansprüche 20 oder 21, **dadurch gekennzeichnet, daß** sie als batterie- und/oder akkumulatorbetriebenes Handgerät ausgebildet ist und eine RFID-Leseeinheit für Read-Only und/oder Read-Write-Transponder enthält.

25. Vorrichtung nach einem der Ansprüche 20 oder 21, **dadurch gekennzeichnet, daß** sie als batterie- und/oder akkumulatorbetriebenes Handgerät ausgebildet ist und eine Strichcode-Leseeinheit enthält.

26. Vorrichtung nach einem der Ansprüche 20 oder 21, **dadurch gekennzeichnet, daß** sie als batterie- oder akkumulatorbetriebenes Handgerät ausgebildet und eine Strichcode-Leseeinheit sowie eine Read-Only und/oder Read-Write-Transponder-Leseeinheit enthält.

27. Vorrichtung nach Anspruch 22 oder 23, **dadurch gekennzeichnet, daß** sie als flexibel fahrbares Standgerät ausgebildet ist und eine RFID-Leseeinheit für Read-Only und/oder Read-Write-Transponder enthält.

28. Vorrichtung nach einem der Ansprüche 22 oder 23, **dadurch gekennzeichnet, daß** sie als flexibel fahrbares Standgerät ausgebildet ist und eine Strichcode-Leseeinheit enthält.

29. Vorrichtung nach einem der Ansprüche 22 oder 23, **dadurch gekennzeichnet, daß** sie als flexibel fahrbares Standgerät ausgebildet ist und eine Strichcode-Leseeinheit sowie eine Read-Only und/oder Read-Write-Transponder Leseeinheit enthält.

## Claims

1. Method for the check of electrical lines and/or electrical consumers in a vehicle on faults particularly on mispluggings and damages, with the steps:
feeding in a frequency signal with a frequency varied automatically over an adjustable range and a voltage level resulting in an essentially idle examination into a fault-free sample of an electrical installation to be checked in form of an electrical line and/or an electrical consumer and storing of a measuring signal arising from the fed in frequency signal in a memory,
feeding in the same frequency signal into an electrical installation to be checked corresponding to the fault-free sample and recording of a measuring signal arising from the fed in frequency signal,
comparing the recorded measuring signal with the reference measuring signal stored in the memory, and
signaling the result of the signal comparison.

2. Method according to claim 1, **characterized in that** the frequency signal is fed in into the sample as well as into the electrical installation to be checked respectively one-sided in which the measuring signal respective the reference measuring signal is recorded at the respective signal injection point.

3. Method according to claim 1 or 2, **characterized in that** an error message is signalized at a difference between the recorded measuring signal and the reference measuring signal around a providable tolerance value.

4. Method according to one of the claims 1 to 3, **characterized in that** the result of the signal comparison is shown optically and/or signalized acoustically.

5. Method according to one of the claims 1 to 4, **characterized in that** the electrical installation to be checked is represented schematically at a display device and examining steps to be carried out are displayed in an examining mask at the display device.

6. Method according to one of the claims 1 to 5, **characterized in that** according to the signal comparison kinds of faults are determined and displayed at a display device.

7. Method according to one of the claims 1 to 6, **characterized in that** a protocol of the measuring signals is carried out and stored.

8. Method according to claim 7, **characterized in that** the carrying out and storing the respective protocol of the measuring signals is made fully automatically.

9. Method according to claim 7 or 8, **characterized in that** the protocol of the measuring signals is transferred wirelessly to a central measuring data acquisition.

10. Device for the check of electrical lines and/or electrical consumers in a vehicle on faults, particularly on mispluggings and damages, with
a device (5, 6) for the generation of a frequency signal with a frequency varied automatically over an adjustable range and a voltage level resulting in an essentially idle examination,
a device (8) for the storage of a reference measuring signal which is measured by feeding in of the frequency signal into a fault-free sample of an electrical installation to be checked in form of an electrical line and/or an electrical consumer, a device for recording a measuring signal resulting from the fed in frequency signal,
a device (9) for the signal evaluation which compares the measured measuring signal with the stored reference measuring signal and
a device (12) which signals the result of the signal comparison.

11. Device according to claim 10, **characterized in that** the device for the generation of a frequency signal shows a frequency generator (5), a device for frequency synthetizing and a reducer (6.)

12. Device according to claim 10 or 11, **characterized in that** the device (9) for the signal evaluation is provided with an analog-digital converter (10) and a programmable logic.

13. Device according to claim 12, **characterized in that** a digital signal filter (11) is post-connected to the analog-digital converter (10).

14. Device according to one of the claims 10 to 13, **characterized in that** furthermore one or several micro controllers are available which control the components of the device.

15. Device according to one of the claims 10 to 14, **characterized in that** furthermore the device contains a replaceble test adapter (15) which shows a storage medium in which storage medium are stored and/or can be stored one or several vehicle specific reference signals, tolerance limits and/or an examining mask.

16. Device according to one of the claims of 10 to 15, **characterized in that** at least one data interface (14) is available, by which reference signals, tolerance limits and/or examining masks can be fed into the device and/or measuring signals are transferable to other devices.

17. Device according to claim 16, **characterized in that** the data interface (14) is got ready for a wireless transmission of data.

18. Device according to one of the claims 10 to 17, **characterized in that** the device (12) for signaling the signal comparison consists of an optical display device and/or an acoustical signal device.

19. Device according to one of the claims 10 to 18, **characterized in that** furthermore an input device in the form of operating devices, a keyboard and/or a touch screen is available.

20. Device according to one of the claims 10 to 19, **characterized in that** the device is formed as a battery and/or accumulator operated hand apparatus.

21. Device according to one of the claims 10 to 20, **characterized in that** the device is formed as a battery and/or accumulator operated hand apparatus and built up in modular technique.

22. Device according to one of the claims 10 to 19, **characterized in that** the device can be operated as a flexibly mobile stand device and with mains current.

23. Device according to claim 22, **characterized in that** the device is formed as a flexibly mobile stand device and built up in modular technique.

24. Device according to one of the claims 20 or 21, **characterized in that** the device is formed as a battery and/or accumulator operated hand apparatus and contains a RFID reading device for Read-Only and/or Read-Write transponder.

25. Device according to one of the claims 20 or 21, **characterized in that** the device is formed as a battery and/or accumulator operated hand apparatus and contains a bar code reading device.

26. Device according to one of the claims 20 or 21, **characterized in that** the device is formed as a battery or accumulator operated hand apparatus and contains a bar code reading device as well as a reading device for Read-Only and/or Read-Write transponder.

27. Device according to claim 22 or 23, **characterized in that** the device is formed as a flexibly mobile stand device and contains a RFID reading device for Read-Only and/or Read-Write transponder.

28. Device according to one of the claims 22 or 23, **characterized in that** the device is formed as a flexibly mobile stand device and contains a bar code reading device.

29. Device according to one of the claims 22 or 23, **characterized in that** the device is formed as a flexibly mobile stand device and contains a bar code reading device as well as a reading device for Read-Only and/or Read-Write transponder.

## Revendications

1. Procédé pour le contrôle de défauts de conducteurs électriques et/ou de consommateurs électriques dans un véhicule, en particulier pour erreurs d'enfichage et endommagements, avec les étapes :
injection d'un signal de fréquence avec une fréquence automatiquement variée sur un intervalle réglable et avec un niveau de tension donnant un contrôle essentiellement sans tension, dans une configuration sans défaut d'une installation électrique à contrôler, sous la forme d'un conducteur électrique et/ou d'un consommateur électrique, et stockage dans une mémoire d'un signal de référence résultant du signal de fréquence,
- injection du même signal de fréquence dans une installation électrique correspondant à la configuration sans défaut, et enregistrement d'un signal de mesure résultant du signal de fréquence injecté,
- comparaison du signal de mesure enregistré au signal de mesure de référence stocké dans la mémoire et
- signalisation du résultat de la comparaison des signaux.

2. Procédé selon la revendication 1, **caractérisé en ce que** le signal de fréquence est injecté respectivement dans la configuration ainsi que dans l'installation électrique à contrôler d'un côté, sachant que le signal de mesure, respectivement le signal de mesure de référence est recueilli à l'endroit respectif d'injection du signal.

3. Procédé selon la revendication 1 ou 2, **caractérisé en ce que**, dans le cas d'un écart d'une valeur de tolérance entre le signal de mesure enregistré et le signal de mesure de référence, un message d'erreur est signalisé.

4. Procédé selon l'une des revendications 1 à 3, **caractérisé en ce que** le résultat de la comparaison des signaux est affiché optiquement et/ou est signalisé acoustiquement.

5. Procédé selon l'une des revendications 1 à 4, **caractérisé en ce que** l'installation électrique à contrôler est représentée schématiquement sur un dispositif d'affichage et **en ce que** les étapes de contrôle à effectuer sont affichées dans un écran de contrôle sur le dispositif d'affichage.

6. Procédé selon l'une des revendications 1 à 5, **caractérisé en ce qu'**au vu de la comparaison des signaux, des types d'erreur sont déterminés et sont signalisés sur un dispositif d'affichage.

7. Procédé selon l'une des revendications 1 à 6, **caractérisé en ce qu'**un rapport des données de mesure est établi et est stocké en mémoire.

8. Procédé selon la revendication 7, **caractérisé en ce que** l'établissement et la mémorisation du rapport de données de mesure respectif s'effectuent automatiquement.

9. Procédé selon la revendication 7 ou 8, **caractérisé en ce que** le rapport de données de mesure est transmis sans fil à une saisie centrale de données de mesure.

10. Dispositif pour le contrôle de défauts de conducteurs électriques et/ou de consommateurs électriques dans un véhicule, en particulier pour erreurs d'enfichage et pour endommagements, avec
- un dispositif (5, 6) pour la génération d'un signal de fréquence avec une fréquence automatiquement variée sur un intervalle réglable et avec un niveau de tension donnant un contrôle essentiellement sans tension,
- un dispositif (8) de stockage en mémoire d'un signal de mesure de référence qui est déterminé par l'injection du signal de fréquence dans une configuration sans défaut d'une installation électrique à contrôler, sous la forme d'un conducteur électrique et/ou d'un consommateur électrique, un dispositif d'enregistrement d'un signal de mesure résultant du signal de fréquence injecté,
- un dispositif (9) de dépouillement des signaux qui compare le signal de mesure enregistré au signal de mesure de référence stocké dans la mémoire et
- un dispositif (12) qui signalise le résultat de la comparaison des signaux.

11. Dispositif selon la revendication 10, **caractérisé en ce que** le dispositif pour la génération du signal de fréquence comporte un générateur de fréquence (5), un dispositif de traitement de la fréquence et un circuit diviseur (6).

12. Dispositif selon la revendication 10 ou 11, **caractérisé en ce que** le dispositif (9) pour le dépouillement du signal est doté d'un convertisseur analogique-numérique (10) et d'une logique programmable.

13. Dispositif selon la revendication 12, **caractérisé en ce qu'**un filtre numérique de signal (11) est monté en aval du convertisseur analogique-numérique (10).

14. Dispositif selon l'une des revendications 10 à 13, **caractérisé en ce qu'**il existe en outre un ou plusieurs microcontrôleurs qui commandent les composants du dispositif.

15. Dispositif selon l'une des revendications 10 à 14, **caractérisé en ce que** le dispositif comprend en outre un adaptateur de contrôle (15) interchangeable qui comporte un support de mémoire sur lequel un ou plusieurs signaux de référence, une ou plusieurs limites de tolérance et/ou un écran de contrôle spécifiques du véhicule sont mémorisés et/ou peuvent être mémorisés.

16. Dispositif selon l'une des revendications 10 à 15, **caractérisé en ce qu'**il existe au moins une interface de données (14) par laquelle des signaux de référence, des limites de tolérance et/ou des écrans de contrôle peuvent être transmis dans le dispositif et/ou par laquelle des données de mesure peuvent être transmises à d'autres dispositifs.

17. Dispositif selon la revendication 16, **caractérisé en ce que** l'interface de données (14) est configurée pour une transmission sans fil des données.

18. Dispositif selon l'une des revendications 10 à 17, **caractérisé en ce que** le dispositif (12) qui signalise la comparaison des signaux consiste en un dispositif d'affichage et/ou en un dispositif de signalisation acoustique.

19. Dispositif selon l'une des revendications 10 à 18, **caractérisé en ce qu'**il existe en outre un dispositif d'entrée, sous la forme d'éléments de commande, d'un clavier et/ou d'un écran tactile.

20. Dispositif selon l'une des revendications 10 à 19, **caractérisé en ce qu'**il est configuré comme appareil à main fonctionnant sur piles et/ou sur accumulateurs.

21. Dispositif selon l'une des revendications 10 à 20, **caractérisé en ce qu'**il est configuré comme appareil à main fonctionnant sur piles et/ou sur accumulateurs et **en ce qu'**il est construit selon une technique modulaire.

22. Dispositif selon l'une des revendications 10 à 19, **caractérisé en ce qu'**il est configuré comme appareil sur pied mobile de façon flexible et **en ce qu'**il peut fonctionner avec le courant du secteur.

23. Dispositif selon la revendication 22, **caractérisé en ce que** qu'il est configuré comme appareil sur pied mobile de façon flexible et **en ce qu'**il est construit selon une technique modulaire.

24. Dispositif selon l'une des revendications 20 ou 21, **caractérisé en ce qu'**il est configuré comme appareil à main fonctionnant sur piles et/ou sur accumulateurs et **en ce qu'**il contient une unité de lecture RFID pour lecture seule et/ou un transpondeur pour lecture-écriture.

25. Dispositif selon l'une des revendications 20 ou 21, **caractérisé en ce qu'**il est configuré comme appareil à main fonctionnant sur piles et/ou sur accumulateurs et **en ce qu'**il contient une unité de lecture de code à barres.

26. Dispositif selon l'une des revendications 20 ou 21, **caractérisé en ce qu'**il est configuré comme appareil à main fonctionnant sur piles et/ou sur accumulateurs et **en ce qu'**il contient une unité de lecture de code à barres ainsi qu'une unité de lecture pour lecture seule et/ou à transpondeur pour lecture-écriture.

27. Dispositif selon la revendication 22 ou 23, **caractérisé en ce qu'**il est configuré comme appareil sur pied mobile de façon flexible et **en ce qu'**il contient une unité de lecture RFID pour lecture seule et/ou un transpondeur pour lecture-écriture.

28. Dispositif selon l'une des revendications 22 ou 23, **caractérisé en ce qu'**il est configuré comme appareil sur pied mobile de façon flexible et **en ce qu'**il contient une unité de lecture de code à barres.

29. Dispositif selon l'une des revendications 22 ou 23, **caractérisé en ce qu'**il est configuré comme appareil sur pied mobile de façon flexible et **en ce qu'**il contient une unité de lecture de code à barres ainsi qu'une unité de lecture pour lecture seule et/ou à transpondeur pour lecture-écriture.
